# EUROPÄISCHE PATENTSCHRIFT

(11) **EP 3 443 415 B1**
(45) Veröffentlichungstag und Bekanntmachung des Hinweises auf die Patenterteilung: **16.06.2021**
(21) Anmeldenummer: 17721517.5
(22) Anmeldetag: 30.03.2017
(51) Int. Cl.: G03B 27/60, H01L 21/683, B23K 37/04, B25B 11/00, G03F 7/20, B41F 15/20, H01L 21/687

(54) **VORRICHTUNG ZUM FIXIEREN VON OBJEKTEN MITTELS VAKUUM**
DEVICE FOR KEEPING OBJECTS IN PLACE BY VACUUM
APPAREIL POUR FIXATION D'OBJETS PAR UN VIDE

(30) Priorität: 12.04.2016 DE 102016106706
(43) Veröffentlichungstag der Anmeldung: 20.02.2019
(73) Patentinhaber: Laser Imaging Systems GmbH, 07745 Jena (DE)
(72) Erfinder: SCHOLZ-GÖRLACH, Urban, 07749 Jena (DE); KLOWSKY, Uwe, 07751 Jena (DE); FLEMMING, Günter, 07751 Zöllnitz (DE)
(74) Vertreter: Oehmke, Volker
(86) Internationale Anmeldenummer: PCT/DE2017/100251
(87) Internationale Veröffentlichungsnummer: WO 2017/178005

(56) Entgegenhaltungen:
- JP-A- H01 201 936
- JP-A- H07 231 033
- JP-A- 2000 012 663
- JP-A- 2007 103 609
- JP-A- 2007 148 414
- US-A- 2 317 348
- US-A- 5 857 667
- US-B1- 6 173 648
- US-B1- 6 422 548

## Beschreibung

Die Erfindung betrifft eine Vorrichtung zum Fixieren von Objekten mittels Vakuum.

Die maschinelle Bearbeitung, Komplettierung oder Inspektion, insbesondere von sehr empfindlichen Objekten, wird teilweise erst durch den Einsatz von Vakuumtischen ermöglicht. Insbesondere bei sehr dünnen und flachen Objekten, wie z. B. Leiterplatten, Flachbildschirmsubstraten, Halbleiterwafern oder auch Druckereierzeugnissen, ist eine Verwendung von anderen, zumeist lokal angreifenden Spannmitteln zum sicheren und zerstörungsfreien Fixieren kaum möglich. Das Fixieren auf einem Vakuumtisch ist für empfindliche Objekte sehr schonend, da die zum Fixieren erforderlichen Kräfte großflächig und gleichmäßig über die Grundfläche der Objekte verteilt werden können. Außerdem ist das Fixieren mittels Vakuum im Vergleich zu anderen Spannmitteln ein sehr schnell und einfach ausführbarer Vorgang.

Damit sich ein Vakuum zum sicheren Fixieren des Objekts auf dem Vakuumtisch ausbilden kann, ist es zunächst erforderlich, dass die Grundfläche des Objekts relativ dicht zur Oberfläche des Vakuumtischs abschließt. Dadurch wird verhindert, dass von der Vakuumabsaugung große Mengen an Umgebungsluft angesaugt werden, wodurch sich kein Unterdruck für das Vakuum erzeugen ließe. Weiterhin ist es insbesondere bei sehr dünnen Objekten erforderlich, dass die Fixierung bis unmittelbar zum Rand der Grundfläche des Objekts erfolgt. Dazu ist die wirksame Fläche des Vakuumtischs i.d.R. entsprechend der Grundfläche des Objekts zu dimensionieren, sodass der Vakuumtisch stets die gesamte Grundfläche bis zum Rand erfasst. In diesem Fall wäre es bei unterschiedlich dimensionierten Objekten mit jeweils anderen Grundflächen erforderlich, für jedes Objekt einen angepassten Vakuumtisch vorzuhalten. Das ist teuer und unpraktikabel.

Sinnvoller ist die Verwendung eines universellen Vakuumtischs. Dieser ist so dimensioniert, dass möglichst alle unterschiedlichen Objekte auf ihm fixiert werden können. Falls die Objekte kleiner als die wirksame Fläche des Vakuumtischs sind, müssen alle nicht vom Objekt abgedeckten Flächen abgedichtet werden, um das Vakuum aufrecht zu erhalten. Aus dem Stand der Technik sind dazu bereits Lösungen bekannt.

Eine Lösung für rotationssymmetrische Grundflächen ist in der Offenlegungsschrift JP H04-159043 A offenbart. Hier wird ein kreisrunder Vakuumtisch beschrieben, der im Wesentlichen aus einem Tisch mit einer Tischplatte besteht, die koaxial aufeinander liegen. Der Tisch weist in einer der Stirnseiten eine radial verlaufende Vakuumkammer auf, die sich linear von der Mitte bis zum Randbereich des Tischs erstreckt. In der Mitte des Tischs ist die Vakuumkammer deutlich breiter als im Randbereich. Die Vakuumkammer hat einen Anschluss zu einer Vakuumabsaugung und wird von der Tischplatte abgedeckt. Auf der Tischplatte werden Objekte mit vorzugsweise kreisförmiger Grundfläche zentrisch abgelegt und mittels Vakuum fixiert. Dazu ist die Oberfläche der Tischplatte mit einer Anzahl konzentrischer Ringnuten versehen. Die Ringnuten verfügen jeweils über zur Unterseite der Tischplatte führende Kanalbohrungen, die entlang einer radial verlaufenden Geraden angeordnet sind. Die Tischplatte kann gegenüber dem Tisch um die gemeinsame Rotationsachse verdreht werden, wobei die Kanalbohrungen relativ zur Vakuumkammer bewegt werden. Je nach Stellung der Kanalbohrungen zur Vakuumkammer ist es möglich, nacheinander, beginnend von der äußersten Kanalbohrung, einzelne Kanalbohrungen außerhalb des Bereichs der Vakuumkammer zu platzieren, sodass die außerhalb der Vakuumkammer liegenden Kanalbohrungen mit dem Tisch verschlossen werden. Beginnend von außen, können so nacheinander einzelne Ringnuten von der Vakuumversorgung getrennt werden. Die wirksame Fläche des Vakuumtischs lässt sich dadurch ringförmig an unterschiedliche Durchmesser der Objekte anpassen, wobei die Abstufung dieses Durchmessers von der Anzahl der in die Tischplatte eingebrachten Ringnuten abhängig ist.

Eine solche Lösung ist jedoch nur bei Objekten mit rotationssymmetrischen oder gleichseitigen Grundflächen sinnvoll einsetzbar. Für rechteckige Grundflächen mit ungleichen Seitenverhältnissen ist diese Lösung ungeeignet.

In der Offenlegungsschrift DE 37 10 404 A1 ist ein Vakuumtisch zum Ansaugen flacher, rechteckiger Objekte offenbart, die in bestimmten Formaten unterschiedlicher Größe vorliegen. Zur Fixierung der unterschiedlichen Objektformate bis in deren Randbereich ist die wirksame Fläche des Vakuumtischs in mehrere rechteckige und einzeln an ein Vakuum anschließbare Zonen unterteilt. Zur Ausbildung der Zonen verfügt der Vakuumtisch über einen Tisch. In den Tisch sind, entsprechend den Zonen, einseitig voneinander abgetrennte Vakuumkammern eingebracht. Die Vakuumkammern des Tischs werden von einer rasterartig perforierten Tischplatte abgedeckt. Auf der Tischplatte können die flächigen Objekte abgelegt und mit Vakuum fixiert werden. Eine erste Vakuumkammer entspricht der Grundfläche des kleinstmöglichen Objektformats. An zwei Seiten der ersten Vakuumkammer ist jeweils eine entsprechend der Größendifferenz zum nächstgrößeren Objektformat dimensionierte weitere Vakuumkammer angeordnet. Mit den weiteren Vakuumkammern wird die wirksame Fläche des Vakuumtischs erweitert. Bis zum Erreichen des größtmöglichen Objektformats sind für jedes größere Objektformat an die weiteren Vakuumkammern angrenzend jeweils weitere Vakuumkammern in den Tisch eingebracht. Zum individuellen Versorgen der einzelnen Vakuumkammern mit Vakuum sind diese jeweils mit einem Schaltventil verbunden, das mittels einer Steuereinrichtung geschaltet wird.

Durch die festgelegte Dimensionierung der Vakuumkammern ist diese Lösung relativ unflexibel, da Objekte, die nicht den vorgesehenen Abstufungen der Objektformate entsprechen, im Randbereich nicht sicher fixiert werden können.

Durch die US 6 422 548 B1 wird ein Vakuumtisch beschrieben, dessen Ansaugbereich zwischen einem minimalen und maximalen Format sowohl in X- als auch Y-Richtung veränderbar ist. Es werden fünf verschiedene Methoden zur Formatverstellung offenbart:
- Die erste Methode besteht darin, dass eine kopfseitige Verstelleinheit (zwei Kolben auf einer gemeinsamen Spindel) L-förmige Bereiche öffnet bzw. schließt, wodurch bei jeder Formatverstellung eine kombinierte Ausdehnung des Ansaugbereiches in X- und Y-Richtung stattfindet.
- Die zweite Methode besteht darin, dass orthogonal angeordnete gelochte Flachschieber an den Kreuzungspunkten der Schieber einen Luftfluss erlauben bzw. blockieren. Damit wird je verstelltem Schieberpaar ein einziger Punkt geschaltet.
- Die dritte Methode ist eine Modifikation der ersten Methode, bei der erstens die Spindel durch Seilzüge ersetzt wird und zweitens eine Schiebereinheit orthogonal zur ersten Methode angeordnet ist, so dass eine unabhängige Verstellung der X- und Y-Ausdehnung ermöglicht wird.
- Die vierte Methode ist eine Kombination aus erster und zweiter Methode, wobei die Flachschieber durch gelochte Rohre ersetzt werden.
- Die fünfte Methode beschreibt eine X- und Y-Verschiebung eines Schlauches, der durch Aufpumpen eine Dichtung bildet und so Vakuum- und Nichtvakuumzonen trennt.

Mit der US 5 857 667 A wird ein Vakuumtisch beschrieben, der eine Formatanpassung in X- und Y-Richtung erlaubt und einzelne Segmente unabhängig voneinander schalten kann. Dazu werden mittels externer Ventile einzelne Bereiche mit der Vakuumquelle verbunden bzw. von dieser getrennt.

Der Erfindung liegt die Aufgabe zugrunde, eine Möglichkeit anzugeben, mit der die wirksame Fläche eines Vakuumtisches fein abgestuft variiert werden kann, so dass Objekte mit unterschiedlich großen Grundflächen sicher arretiert werden können.

Die Aufgabe wird durch eine Vorrichtung zum Fixieren von Objekten mittels Vakuum, umfassend einen in x- und y-Richtung ausgedehnten Tisch mit mehreren Vakuumkammern, die zum flächigen Verteilen eines an den Tisch angeschlossenen Vakuums in z-Richtung in den Tisch eingebracht sind, und mit einer Tischplatte, die den Tisch und die Vakuumkammern abdeckend angeordnet ist und rasterartig eine Vielzahl von Perforationslöchern aufweist, wobei unmittelbar unter der Tischplatte eine erste Vakuumkammer, ein Mindestformat einer wirksamen Fläche des Tischs in x- und y-Richtung festlegend, anliegend an zwei benachbarten Seitenflächen des Tischs angeordnet und permanent an eine mit dem Tisch verbundene Vakuumabsaugung angeschlossen ist und weitere Vakuumkammern, eine Erweiterung der wirksamen Fläche über das Mindestformat hinaus ermöglichend, anliegend an mindestens einer Seite der ersten Vakuumkammer und / oder an mindestens einer der Seiten der weiteren Vakuumkammern angeordnet sind und alle weiteren Vakuumkammern eine schaltbare Verbindung zur Vakuumabsaugung aufweisen, dadurch gelöst, dass auf dem Tisch neben der ersten Vakuumkammer eine die erste Vakuumkammer auf die gesamte Ausdehnung in y-Richtung erweiternde zweite Vakuumkammer und eine die erste Vakuumkammer und die zweite Vakuumkammer auf die gesamte Ausdehnung in x-Richtung erweiternde dritte Vakuumkammer angeordnet ist, wobei die zweite Vakuumkammer eine Struktur aus einer Vielzahl paralleler und in x-Richtung verlaufender zeilenbildender Nuten aufweist, die über einen ersten Verbindungskanal in y-Richtung miteinander verbunden und mittels einer Zeilenschalteinrichtung zur ersten Vakuumkammer seriell freigeb- oder verschließbar sind, die dritte Vakuumkammer eine Struktur aus einer Vielzahl paralleler und in y-Richtung verlaufender spaltenbildender Nuten aufweist, die über einen zweiten Verbindungskanal in x-Richtung miteinander verbunden und mittels einer Spaltenschalteinrichtung zur ersten Vakuumkammer seriell freigeb- oder verschließbar sind, und die dritte Vakuumkammer mittels der Zeilenschalteinrichtung gleichzeitig abschnittsweise und entsprechend der Anzahl und den Positionen der zeilenbildenden Nuten in Übereinstimmung zur zweiten Vakuumkammer seriell in y-Richtung freigeb- oder verschließbar ist, um eine spalten- und zeilenweise Größenanpassung der wirksamen Fläche des Tischs in x- und / oder y-Richtung zu erreichen.

Nachfolgend soll die Erfindung anhand von Ausführungsbeispielen näher erläutert werden. In den zugehörigen Zeichnungen zeigen:
- Fig. 1: einen prinzipiellen Aufbau der Vorrichtung zum Fixieren von Objekten mittels Vakuum in einer perspektivischen Ansicht,
- Fig. 2: ein weiteres Ausführungsbeispiel des Tischs in einer Ansicht von oben, mit angedeuteten Umrissen der Vakuumkammern,
- Fig. 3a: einen prinzipiellen Aufbau des Verteilergehäuses im vollständig geschlossenen Zustand der Spaltenschalteinrichtung,
- Fig. 3b: einen prinzipiellen Aufbau des Verteilergehäuses im vollständig geöffneten Zustand der Spaltenschalteinrichtung,
- Fig. 4: ein weiteres Ausführungsbeispiel des Tischs in einer Ansicht von oben, mit einer wirksamen Fläche größer als das Mindestformat und
- Fig. 5: einen prinzipiellen Aufbau der Zeilenschalteinrichtung mit Linearantrieb und Blendenschieber in einer Teilschnittdarstellung des Tischs.

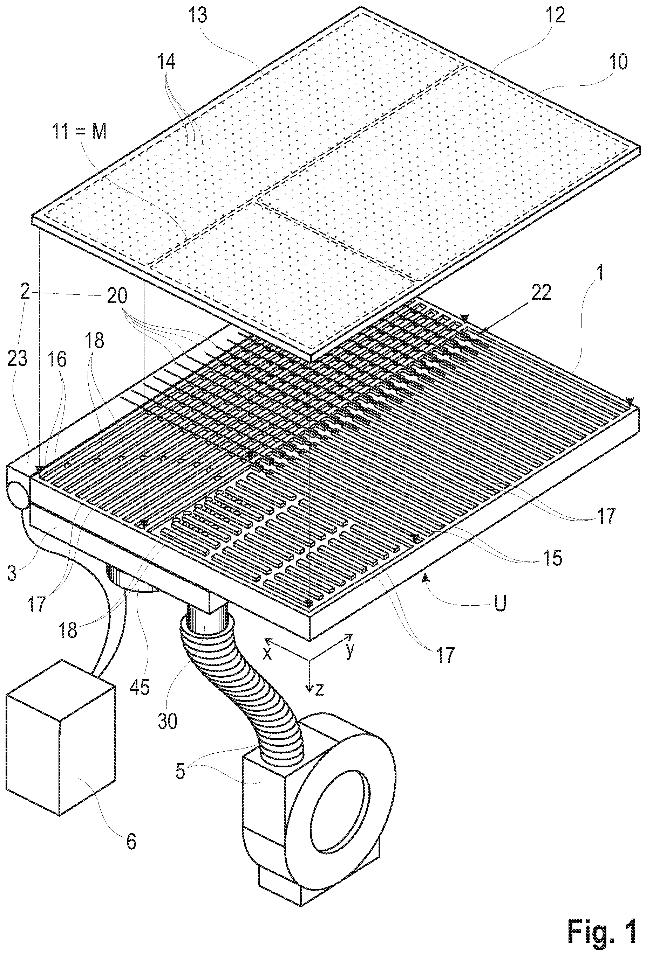

Die Vorrichtung zum Fixieren von Objekten mittels Vakuum ist prinzipiell wie in Fig. 1 dargestellt aufgebaut. Sie umfasst einen in x- und y-Richtung ausgedehnten Tisch 1 mit in z-Richtung in den Tisch 1 eingebrachten Vakuumkammern 11, 12, 13 zum flächigen Verteilen eines an den Tisch 1 angeschlossenen Vakuums. Die Vakuumkammern 11, 12, 13 sind mit einer Tischplatte 10 abgedeckt. In der Tischplatte 10 sind rasterartig eine Vielzahl von Perforationslöchern 14 angeordnet.

Unmittelbar unter der Tischplatte 10 ist, anliegend an zwei benachbarten Seitenflächen des Tischs 1, eine erste Vakuumkammer 11 angeordnet. Die erste Vakuumkammer 11 ist permanent an eine mit dem Tisch 1 verbundene Vakuumabsaugung 5 angeschlossen. Sie bestimmt ein Mindestformat M einer wirksamen Fläche W des Tischs 1 in x- und y-Richtung.

Eine zweite Vakuumkammer 12 und eine dritte Vakuumkammer 13 ermöglichen eine Erweiterung der wirksamen Fläche W des Tischs 1 über das Mindestformat M der ersten Vakuumkammer 11 hinaus. Die zweite Vakuumkammer 12 ist anliegend an einer Seite der ersten Vakuumkammer 11 angeordnet. Die dritte Vakuumkammer 13 ist anliegend an jeweils einer Seite der ersten Vakuumkammer 11 und der zweiten Vakuumkammer 12 angeordnet. Die zweite und dritte Vakuumkammer 12, 13 weisen jeweils eine schaltbare Verbindung zur Vakuumabsaugung 5 auf.

Bei einer in Fig. 1 gezeigten Ausführung der Vorrichtung ist die Tischplatte 10 in einer vom Tisch 1 abgehobenen Position dargestellt, um eine bessere Sichtbarkeit der Vakuumkammern 11, 12, 13 zu ermöglichen. Aus Gründen der Übersichtlichkeit sind die Umrisse der Vakuumkammern 11, 12, 13 und des Mindestformats M in Fig. 1 als Projektion auf der Tischplatte 10 in Form von unterbrochenen Linien dargestellt.

Wie in Fig. 1 gezeigt, ist die erste Vakuumkammer 11, anliegend an einer Ecke des Tischs 1, rechteckig in x- und y-Richtung ausgedehnt. Die Abmessungen der ersten Vakuumkammer 11 sind in der Regel deutlich kleiner als die des Tischs 1 und sind vorteilhaft an die Abmessungen eines kleinsten aufzunehmenden Objekts angepasst, welches beispielsweise durch Standards vorgegeben sein kann. Durch die Abmessungen der ersten Vakuumkammer 11 wird deshalb das Mindestformat M des Tischs 1 bestimmt. Die Abmessungen des Objekts sollten wenigstens dem Mindestformat M entsprechen, um es sicher mit der Vorrichtung zu fixieren. Da die gesamte erste Vakuumkammer 11 permanent an das Vakuum der Vakuumabsaugung 5 angeschlossen ist, wird auch die kleinste wirksame Fläche W des Tischs 1 durch das Mindestformat M festgelegt.

Innerhalb der ersten Vakuumkammer 11 sind in regelmäßigen Abständen Stützstrukturen 17 angeordnet. Bei montierter Tischplatte 10 liegt die Tischplatte 10 im Bereich der ersten Vakuumkammer 11 auf den Stützstrukturen 17 auf. Dadurch wird die Ebenheit der Tischplatte 10 unter Einwirkung des Vakuums oder der Gewichtskraft von aufliegenden Objekten gewährleistet. Die Stützstrukturen 17 können in der ersten Vakuumkammer 11 beliebige Formen aufweisen, solange die Perforationslöcher 14 der Tischplatte 10 nicht blockiert werden und eine gleichmäßige und ungehinderte Versorgung der gesamten ersten Vakuumkammer 11 mit Vakuum gegeben ist.

Für den Anschluss an das Vakuum sind in z-Richtung verlaufende Zugangsbohrungen 18 in der ersten Vakuumkammer 11 angeordnet. Die Zugangsbohrungen 18 sind an einer der Tischplatte 10 gegenüberliegenden Unterseite U des Tischs 1 aus dem Tisch 1 herausgeführt. Die Anzahl und Größe der Zugangsbohrungen 18 können variieren und sind entsprechend den Platzverhältnissen zwischen den Stützstrukturen 17 angepasst.

Zum Erweitern der wirksamen Fläche W auf die gesamte Ausdehnung des Tischs 1 in x- und y-Richtung und über das Mindestformat M hinaus sind die zweite und dritte Vakuumkammer 12 und 13 vorgesehen.

Die zweite Vakuumkammer 12 schließt sich unmittelbar an die erste Vakuumkammer 11 an. Sie ist ebenfalls rechteckig in x- und y-Richtung ausgedehnt und weist in x-Richtung die gleiche Abmessung wie die erste Vakuumkammer 11 auf. In y-Richtung erstreckt sie sich über die neben der ersten Vakuumkammer 11 verbleibende Ausdehnung des Tischs 1 in y-Richtung.

Innerhalb ihrer x-y-Ausdehnung ist die zweite Vakuumkammer 12 in eine Vielzahl paralleler und in x-Richtung verlaufender zeilenbildender Nuten 15 strukturiert. Zwischen den zeilenbildenden Nuten 15 verbleibende Abstände werden, wie zur ersten Vakuumkammer 11 beschrieben, als Stützstruktur 17 für die Tischplatte 10 verwendet. Durch die konstruktive Festlegung der Abmessungen und Abstände der zeilenbildenden Nuten 15 ist eine gewünschte Abstufung bei einer Größenanpassung der wirksamen Fläche W, im Bereich zwischen dem Mindestformat M und der maximalen Ausdehnung des Tischs 1 in x- und y-Richtung, einstellbar.

Die zeilenbildenden Nuten 15 sind über einen in y-Richtung verlaufenden ersten Verbindungskanal 22 miteinander verbunden. Der erste Verbindungskanal 22 ist an der zur dritten Vakuumkammer 13 angrenzenden Seite innerhalb der zweiten Vakuumkammer 12 angeordnet. Er ist bis in die erste Vakuumkammer 11 verlaufend fortgesetzt, sodass die zweite Vakuumkammer 12 über den ersten Verbindungskanal 22 an das Vakuum der ersten Vakuumkammer 11 angeschlossen ist.

Die dritte Vakuumkammer 13 ist benachbart zur ersten und zweiten Vakuumkammer 11 und 12 auf dem Tisch 1 angeordnet. Sie ist rechteckig und erstreckt sich über die neben der ersten und zweiten Vakuumkammer 11, 12 verbleibende Ausdehnung des Tischs 1 in x- und y-Richtung.

Innerhalb ihrer x-y-Ausdehnung ist die dritte Vakuumkammer 13 in eine Vielzahl paralleler und in y-Richtung verlaufender spaltenbildender Nuten 16 strukturiert. Durch die spaltenbildenden Nuten 16 erfolgt eine Unterteilung der dritten Vakuumkammer 13 in x-Richtung. Durch die konstruktive Festlegung der Abmessungen und Abstände der spaltenbildenden Nuten 16 ist eine gewünschte Abstufung bei der Größenanpassung der wirksamen Fläche W einstellbar. Die zwischen den spaltenbildenden Nuten 16 verbleibenden Abstände werden, wie zur ersten Vakuumkammer 11 beschrieben, als Stützstruktur 17 für die Tischplatte 10 verwendet.

Der Zugang zu den spaltenbildenden Nuten 16 wird mit jeweils einer in z-Richtung eingebrachten Zugangsbohrung 18 hergestellt, die an der Unterseite U aus dem Tisch 1 herausgeführt ist. Die Verbindung der spaltenbildenden Nuten 16 erfolgt außerhalb der dritten Vakuumkammer 13 über einen zweiten Verbindungskanal 42, in den die Zugangsbohrungen 18 einmünden. Der zweite Verbindungskanal 42 ist Bestandteil eines Verteilergehäuses 3, das weiter unten beschrieben wird.

Für die Unterteilung der zweiten Vakuumkammer 12, entsprechend der Anordnung der zeilenbildenden Nuten 15, ist am Tisch 1 eine Zeilenschalteinrichtung 2 angeordnet. Die Zeilenschalteinrichtung 2 verfügt über einen seriell wirksamen Linearantrieb 23 und über eine Vielzahl von Blendenschiebern 20. Die Anzahl der Blendenschieber 20 entspricht der Anzahl der zeilenbildenden Nuten 15. Mit der Zeilenschalteinrichtung 2 können die durch den ersten Verbindungskanal 22 geschaffenen Verbindungen zwischen den einzelnen zeilenbildenden Nuten 15 und zwischen der ersten und zweiten Vakuumkammer 11 und 12 seriell nacheinander freigegeben oder verschlossen werden. Die Ansteuerung der Zeilenschalteinrichtung 2 erfolgt mit einer Steuereinrichtung 6, die mit dem Linearantrieb 23 verbunden ist.

Die Blendenschieber 20 sind Blechstreifen, die in x-Richtung verlaufend und parallel zur x-z-Ebene im Tisch 1 aufgenommen sind. Die Aufnahme der Blendenschieber 20 erfolgt so, dass sie in x-Richtung im Tisch 1 beweglich sind. In der zweiten Vakuumkammer 12 sind die Blendenschieber 20 jeweils genau mittig in den zwischen den zeilenbildenden Nuten 15 verbleibenden Abständen, also mittig zu den Stützstrukturen 17 verlaufend angeordnet. Sie durchqueren dabei den Querschnitt des ersten Verbindungskanals 22, sodass mit jedem Blendenschieber 20 jeweils ein zwischen den Blendenschiebern 20 liegender Abschnitt des ersten Verbindungskanals 22 und die dazugehörige zeilenbildende Nut 15 freigegeben oder verschlossen werden kann.

Zum Freigeben der zeilenbildenden Nuten 15 verfügen die Blendenschieber 20 innerhalb der zweiten Vakuumkammer 12 über einen Durchbruch 21 in y-Richtung. Im verschlossenen Zustand befindet sich der Durchbruch 21 des Blendenschiebers 20 innerhalb der Stützstruktur 17. Mittels der Stützstruktur 17 wird der Durchbruch 21 abgedeckt und abgedichtet. Zum Freigeben wird der Blendenschieber 20 mit dem Linearantrieb 23 in x-Richtung bewegt, bis sich der Durchbruch 21 im Querschnitt des ersten Verbindungskanals 22 befindet. Zur Verdeutlichung sind in Fig. 1 die ersten sieben der der ersten Vakuumkammer 11 folgenden Blendenschieber 20 in einem geöffneten und alle weiteren Blendenschieber 20 in einem geschlossenen Zustand dargestellt.

Ausgehend von der zweiten Vakuumkammer 12 verlaufen die Blendenschieber 20 in x-Richtung durch die dritte Vakuumkammer 13 hindurch und sind, auf der Seite der dritten Vakuumkammer 13, seitlich aus dem Tisch 1 heraus geführt. Die herausgeführten Enden der Blendenschieber 20 sind mit dem dort angeordneten Linearantrieb 23 verbunden. Mit dem seriell wirksamen Linearantrieb 23 können die Blendenschieber 20, beginnend an der ersten Vakuumkammer 11 und sich in y-Richtung fortsetzend, nacheinander geöffnet bzw. in umgekehrter Richtung wieder geschlossen werden.

Mit den durch die dritte Vakuumkammer 13 hindurch verlaufenden Blendenschiebern 20 kann auch die dritte Vakuumkammer 13, entsprechend den zeilenbildenden Nuten 15 der zweiten Vakuumkammer 12, in y-Richtung unterteilt werden. Innerhalb der dritten Vakuumkammer 13 erfolgt die bewegliche Lagerung der Blendenschieber 20 in den Stützstrukturen 17. Die Blendenschieber 20 durchqueren dabei die Querschnitte der spaltenbildenden Nuten 16. Mit jedem Blendenschieber 20 wird, parallel zu einer der zeilenbildenden Nuten 15 der zweiten Vakuumkammer 12, jeweils der zwischen den Blendenschiebern 20 liegende Abschnitt aller spaltenbildenden Nuten 16 freigegeben oder verschlossen.

Zum Freigeben der Abschnitte der spaltenbildenden Nuten 16 sind im Bereich der dritten Vakuumkammer 13 weitere Durchbrüche 21 in den Blendenschiebern 20 angeordnet. Die Anzahl und Positionen der Durchbrüche 21 entsprechen der Anzahl und den Positionen der spaltenbildenden Nuten 16. Im verschlossenen Zustand befinden sich die Durchbrüche 21 im Bereich der Stützstrukturen 17. Mittels der Stützstrukturen 17 werden die Durchbrüche 21 verdeckt und abgedichtet. Die Größe der Durchbrüche 21 und die Abstände zwischen den spaltenbildenden Nuten 16 bzw. die Querschnitte der Stützstrukturen 17 sind aufeinander angepasst, um im geschlossenen Zustand der Blendenschieber 20 eine vollständige Abdeckung und Abdichtung der Durchbrüche 21 zu erreichen. Wie in Fig. 1 an den ersten sieben Blendenschiebern 20 gezeigt, werden die Blendenschieber 20 zum Freigeben mit dem Linearantrieb 23 in x-Richtung bewegt, bis sich die Durchbrüche 21 in den Querschnitten der spaltenbildenden Nuten 16 befinden.

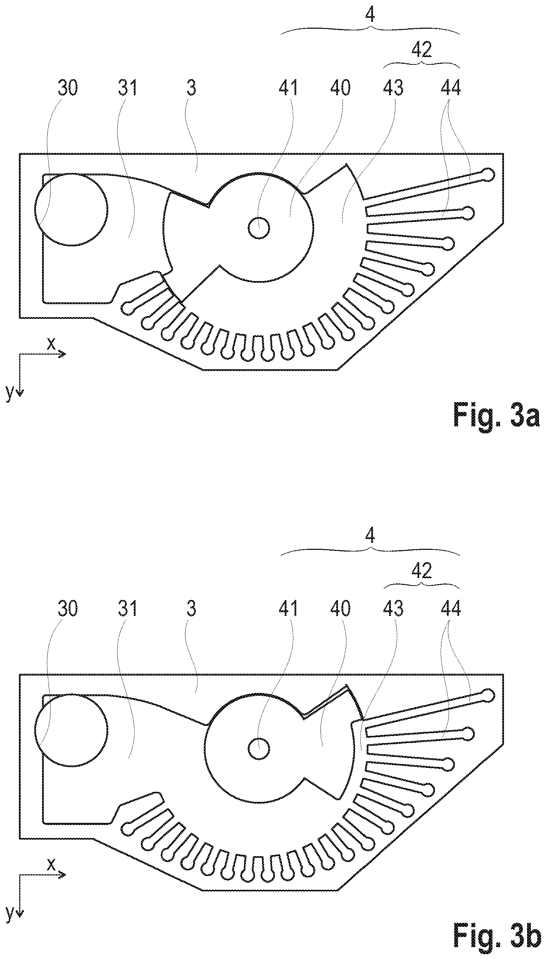

In Fig. 3a und 3b ist das oben bereits im Zusammenhang mit der dritten Vakuumkammer 13 erwähnte plattenförmige Verteilergehäuse 3 dargestellt. Es ist mit der Unterseite U des Tischs 1 verbunden und ist für den Anschluss und die Verteilung des Vakuums vorgesehen. Es beinhaltet einen Anschlussflansch 30 für die Vakuumabsaugung 5 und eine Spaltenschalteinrichtung 4 für die dritte Vakuumkammer 13. Das plattenförmige Verteilergehäuse 3 ist in x- und y-Richtung mindestens so dimensioniert, dass alle Zugangsbohrungen 18 der ersten und dritten Vakuumkammer 11 und 13 an der Unterseite U des Tischs 1 in das Verteilergehäuse 3 münden können.

Wie bereits in Fig. 1 gezeigt, ist der Anschlussflansch 30 im Bereich unterhalb der ersten Vakuumkammer 11 aus dem Verteilergehäuse 3 herausgeführt. An den Anschlussflansch 30 ist die Vakuumabsaugung 5 angeschlossen. Er mündet innerhalb des Verteilergehäuses 3 in einer Ausnehmung 31. Im Bereich der Ausnehmung 31 sind alle Zugangsbohrungen 18 der ersten Vakuumkammer 11 im Tisch 1 angeordnet.

Die Spaltenschalteinrichtung 4 wird aus dem zweiten Verbindungskanal 42 und einem um eine in z-Richtung orientierte Drehachse 41 drehbaren Drehschieber 40 gebildet. Der zweite Verbindungskanal 42 ist direkt an die Ausnehmung 31 angeschlossen, wobei die Abtrennung des zweiten Verbindungskanals 42 vom permanent in der Ausnehmung 31 anliegenden Vakuum mit dem Drehschieber 40 erfolgt. Der zweite Verbindungskanal 42 weist eine nahezu halbkreisförmige und um die Drehachse 41 angeordnete Kammer 43 zur beweglichen Aufnahme des Drehschiebers 40 auf. Von der Kammer 43 führen einzelne kanalförmige Zugänge 44 bis zu den Zugangsbohrungen 18 der spaltenbildenden Nuten 16 der dritten Vakuumkammer 13. Die Zugänge 44 sind radial zur Drehachse 41 angeordnet und verfügen jeweils über eine mittels des Drehschiebers 40 verschließ- und abdichtbare Einmündung in die Kammer 43.

Die Verwendung des Drehschiebers 40 soll keine Beschränkung für die konstruktive Gestaltung der Spaltenschalteinrichtung 4 darstellen. Prinzipiell ist auch jede andere Anordnung von schaltbaren Ventilen für die Spaltenschalteinrichtung 4 geeignet. Der Drehschieber 40 und die radiale Anordnung der Zugänge 44 bieten hier insbesondere den Vorteil, eine möglichst große Aufspreizung des zweiten Verbindungskanals 42 in x-Richtung bei gleichzeitig kompakter Gestaltung der Spaltenschalteinrichtung 4 zu erreichen, wodurch die Größe von abzudichtenden Flächen auf ein Minimum reduziert werden kann.

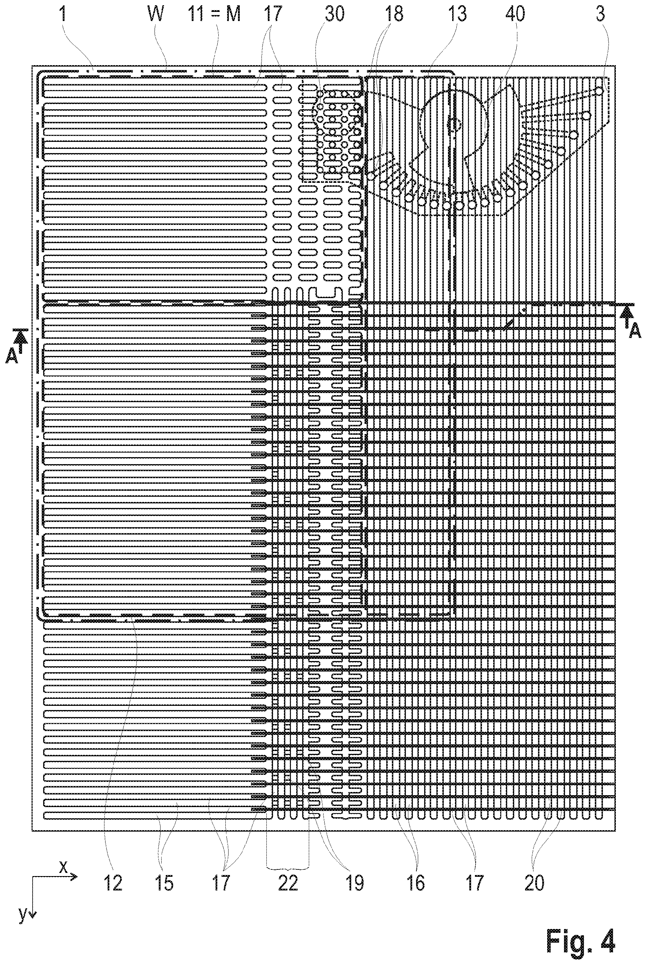

Durch eine Rotationsbewegung des Drehschiebers 40 um die Drehachse 41 können die Einmündungen der Zugänge 44 nacheinander freigegeben oder verschlossen werden, sodass die spaltenbildenden Nuten 16 der dritten Vakuumkammer 13 seriell mit dem Vakuum der ersten Vakuumkammer 11 verbunden oder vom Vakuum abgetrennt werden. In Fig. 3a ist der Drehschieber 40 in einem vollständig geschlossenen Zustand dargestellt. Im geschlossenen Zustand ist der zweite Verbindungskanal 42 und damit auch die dritte Vakuumkammer 13 vollständig vom Vakuum abgetrennt. Fig. 3b zeigt den Drehschieber 40 in einem vollständig geöffneten Zustand. In diesem Zustand sind alle Zugänge 44 des zweiten Verbindungskanals 42 freigegeben, sodass alle spaltenbildenden Nuten 16 der dritten Vakuumkammer 13 mit dem Vakuum verbunden sind. Zwischen dem geschlossenen und dem geöffneten Zustand sind, wie in Fig. 4 dargestellt, auch Zwischenzustände des Drehschiebers 40 möglich.

Die Rotationsbewegung des Drehschiebers 40 wird mittels eines in Fig. 1 gezeigten Rotationsantriebs 45 erzeugt. Der Rotationsantrieb 45 ist mit der Steuereinrichtung 6 verbunden, durch welche die Bewegung der Spaltenschalteinrichtung 4 gesteuert wird. Der Rotationsantrieb 45 verfügt über ein selbsthemmendes Getriebe (nicht dargestellt), mit dem z. B. ein durch die Kraft der Vakuumabsaugung 5 verursachtes Bewegen des Drehschiebers 40 verhindert wird.

Durch eine kombinierte Verwendung der Zeilenschalteinrichtung 2 und der Spaltenschalteinrichtung 4 ist es mit der Vorrichtung zum Fixieren von Objekten mittels Vakuum möglich, eine sehr differenzierte Größenanpassung der wirksamen Fläche W des Tischs 1 in x- und / oder y-Richtung vorzunehmen, wobei die Erweiterung oder Verkleinerung in beiden Richtungen unabhängig voneinander erfolgen kann. Dadurch können, zwischen dem Mindestformat M und der maximalen x-y-Ausdehnung des Tischs 1, beliebige Objektformate sicher fixiert werden.

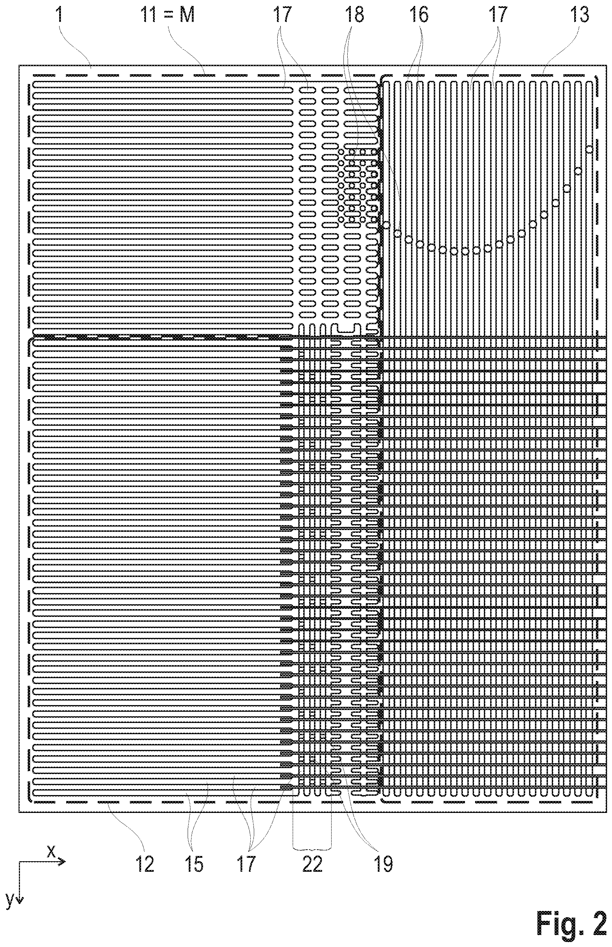

In Fig. 2 ist eine andere Ausführung des Tischs 1 gezeigt. Im Vergleich zu dem in Fig. 1 dargestellten Ausführungsbeispiel sind die zweite und dritte Vakuumkammer 12 und 13 hier wesentlich feiner unterteilt. Die feinere Unterteilung wird durch schmalere zeilenbildende Nuten 15 bzw. spaltenbildende Nuten 16 und entsprechend geringere Abstände zwischen diesen erreicht. Die Umrisse der Vakuumkammern 11, 12, 13 und des Mindestformats M sind mit unterbrochenen Linien dargestellt. Für eine ausreichende Versorgung der zweiten Vakuumkammer 12 mit dem Vakuum ist der erste Verbindungskanal 22 breiter ausgeführt. Über die Breite sind in y-Richtung verlaufende Stützstrukturen 17 innerhalb des ersten Verbindungskanals 22 angeordnet, wobei die Stützstrukturen 17 in regelmäßigen Abständen mittels Querverbindungen 19 in x-Richtung unterbrochen sind. Die feinere Unterteilung gestattet eine noch differenziertere Größenanpassung der wirksamen Fläche W des Tischs 1 an die Abmessungen eines Objektformats.

Bei dem in Fig. 4 gezeigten Ausführungsbeispiel ist die Größe der wirksamen Fläche W auf eine zwischen dem Mindestformat M und der maximalen Ausdehnung des Tischs 1 angepasste Zwischengröße in x- und y-Richtung eingestellt. Die wirksame Fläche W ist mit einer Strich-Punkt-Linie dargestellt. Der Anteil der einzelnen Vakuumkammern 11, 12, 13 an der wirksamen Fläche W ist mit unterbrochenen Linien dargestellt. Das an der Unterseite U des Tischs 1 befestigte Verteilergehäuse 3 ist mit einer gepunkteten Linie angedeutet.

Die ausschließliche Erweiterung der wirksamen Fläche W in y-Richtung über das Mindestformat M hinaus erfolgt in der zweiten Vakuumkammer 12 mit den Blendenschiebern 20 der Zeilenschalteinrichtung 2. Die Blendenschieber 20, die benachbart zur ersten Vakuumkammer 11 innerhalb der einzustellenden wirksamen Fläche W liegen, befinden sich im geöffneten Zustand. Im geöffneten Zustand sind die vom jeweiligen Blendenschieber 20 freigegebenen zeilenbildenden Nuten 15 über den ersten Verbindungskanal 22 an das Vakuum angeschlossen. Alle Blendenschieber 20 außerhalb der einzustellenden wirksamen Fläche W befinden sich im geschlossenen Zustand.

Die ausschließliche Erweiterung der wirksamen Fläche W in x-Richtung über das Mindestformat M hinaus erfolgt in der dritten Vakuumkammer 13 mit dem Drehschieber 40 der Spaltenschalteinrichtung 4. In dem in Fig. 4 gezeigten Zwischenzustand des Drehschiebers 40 ist nur etwa das erste Drittel der an die erste Vakuumkammer 11 angrenzenden spaltenbildenden Nuten 16 der dritten Vakuumkammer 13 an das Vakuum angeschlossen.

Die gleichzeitige Erweiterung der wirksamen Fläche W in x- und y-Richtung über das Mindestformat M hinaus erfolgt in dem der zweiten Vakuumkammer 12 in x-Richtung benachbarten Teil der dritten Vakuumkammer 13. Dieser Bereich des Tischs 1 kann nur mit Vakuum versorgt werden, wenn gleichzeitig die Zeilenschalteinrichtung 2 und die Spaltenschalteinrichtung 4 freigegeben sind. Für eine zeilen- und spaltenweise Größenanpassung der wirksamen Fläche W wird eine sich überschneidende Wirkung der Zeilen- und der Spaltenschalteinrichtung 2 und 4 in diesem Bereich genutzt.

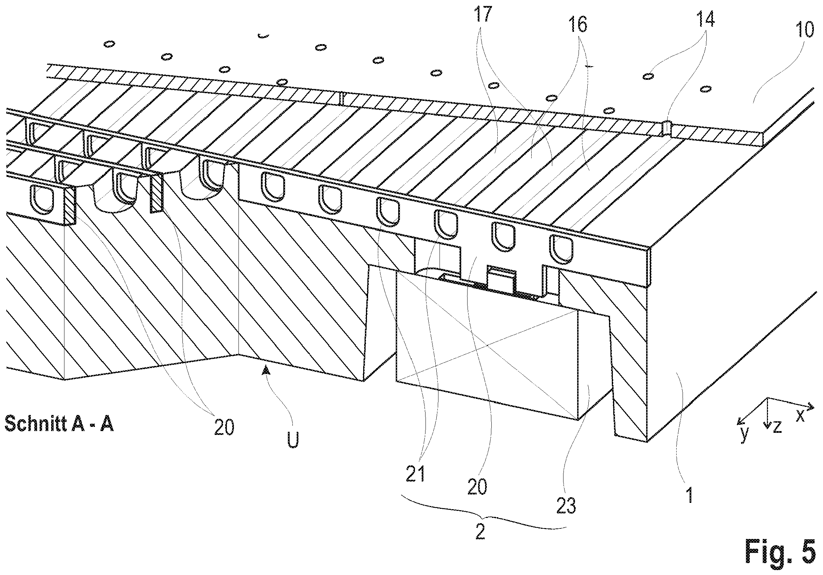

In Fig. 5 sind der Tisch 1 und die Tischplatte 10 in einem Teilschnitt A-A durch die dritte Vakuumkammer 13 gezeigt. In der hier dargestellten Ausführung ist der seriell wirksame Linearantrieb 23 an der Unterseite U am Tisch 1 befestigt. Die Blendenschieber 20 weisen einen Abschnitt auf, der in z-Richtung durch den Tisch 1 hindurch geführt ist und mit dem Linearantrieb 23 in einer Wirkverbindung steht. Der Linearantrieb 23 und die Wirkverbindung werden hier nicht näher ausgeführt. Als Linearantrieb 23 ist jede Form geeignet, mit der sich die Blendenschieber 20 einzeln und seriell nacheinander in x-Richtung bewegen lassen. Die Blendenschieber 20 sind im geöffneten Zustand gezeigt. Im geöffneten Zustand befinden sich die Durchbrüche 21 in den Querschnitten der spaltenbildenden Nuten 16 der dritten Vakuumkammer 13, sodass diese, in Abhängigkeit vom Zustand der Spaltenschalteinrichtung 4, an das Vakuum angeschlossen sind.

Zum Einnehmen des geschlossenen Zustands werden die Blendenschieber 20 vom Linearantrieb 23 in x-Richtung in den Tisch 1 hinein bewegt, bis die Durchbrüche 21 vollständig innerhalb der Querschnitte der Stützstrukturen 17 positioniert sind.

Durch serielles Öffnen oder Schließen der Blendenschieber 20 werden die mittels der Spaltenschalteinrichtung 4 freigegebenen spaltenbildenden Nuten 16 der dritten Vakuumkammer 13 mit jedem Blendenschieber 20 jeweils um die Breite einer zeilenbildenden Nut 15 in y-Richtung erweitert oder verkleinert.

In einem weiteren, nicht dargestellten Ausführungsbeispiel ist die wirksame Fläche W zu beiden Seiten der ersten Vakuumkammer 11 in x- und / oder y-Richtung erweiterbar. Dazu ist die aus den bisher beschriebenen Ausführungsbeispielen bekannte Anordnung der ersten, zweiten und dritten Vakuumkammer 11, 12 und 13 mit der ersten Vakuumkammer 11 in das Zentrum des Tischs 1 verschoben angeordnet. Zu beiden Seiten der ersten Vakuumkammer 11 sind dann die zweite Vakuumkammer 12 mit der Zeilenschalteinrichtung 2 und die dritte Vakuumkammer 13 mit der Spaltenschalteinrichtung 4 jeweils doppelt, und zwar jeweils spiegelsymmetrisch zur ersten Vakuumkammer 11, auf dem Tisch 1 angeordnet.

Die Erfindung wird durch die Ansprüche definiert. Ausführungsbeispiele, die nicht durch die Ansprüche abgedeckt sind, sind als Vergleichsbeispiele zu betrachten.

### Bezugszeichenliste

- 1: Tisch
- 10: Tischplatte
- 11: erste Vakuumkammer
- 12: zweite Vakuumkammer
- 13: dritte Vakuumkammer
- 14: Perforationslöcher
- 15: zeilenbildende Nut
- 16: spaltenbildende Nut
- 17: Stützstruktur
- 18: Zugangsbohrung
- 19: Querverbindungen (in den Stützstrukturen 17 des ersten Verbindungskanals 22)
- 2: Zeilenschalteinrichtung
- 20: Blendenschieber
- 21: Durchbruch
- 22: erster Verbindungskanal
- 23: Linearantrieb
- 3: Verteilergehäuse
- 30: Anschlussflansch
- 31: Ausnehmung
- 4: Spaltenschalteinrichtung
- 40: Drehschieber
- 41: Drehachse
- 42: zweiter Verbindungskanal
- 43: Kammer
- 44: Zugänge
- 45: Rotationsantrieb
- 5: Vakuumabsaugung
- 6: Steuereinrichtung
- M: Mindestformat
- U: Unterseite (des Tischs 1)
- W: wirksame Fläche

## Patentansprüche

1. Vorrichtung zum Fixieren von Objekten mittels Vakuum, umfassend einen in x- und y-Richtung ausgedehnten Tisch (1) mit mehreren Vakuumkammern, die zum flächigen Verteilen eines an den Tisch (1) angeschlossenen Vakuums in z-Richtung in den Tisch (1) eingebracht sind, und mit einer Tischplatte (10), die den Tisch (1) und die Vakuumkammern abdeckend angeordnet ist und rasterartig eine Vielzahl von Perforationslöchern (14) aufweist, wobei unmittelbar unter der Tischplatte (10) eine erste Vakuumkammer (11), ein Mindestformat (M) einer wirksamen Fläche (W) des Tischs (1) in x- und y-Richtung festlegend, anliegend an zwei benachbarten Seitenflächen des Tischs (1) angeordnet und permanent an eine mit dem Tisch (1) verbundene Vakuumabsaugung (5) angeschlossen ist und weitere Vakuumkammern, eine Erweiterung der wirksamen Fläche (W) über das Mindestformat (M) hinaus ermöglichend, anliegend an mindestens einer Seite der ersten Vakuumkammer (11) und / oder an mindestens einer der Seiten der weiteren Vakuumkammern angeordnet sind und alle weiteren Vakuumkammern eine schaltbare Verbindung zur Vakuumabsaugung (5) aufweisen, **dadurch gekennzeichnet, dass**
- ein Verteilergehäuse (3) am Tisch (1) angeordnet ist, mittels dem die Vakuumabsaugung (5) am Tisch (1) angeschlossen ist,
- auf dem Tisch (1) neben der ersten Vakuumkammer (11) eine die erste Vakuumkammer (11) auf die gesamte Ausdehnung in y-Richtung erweiternde zweite Vakuumkammer (12) und eine die erste Vakuumkammer (11) und die zweite Vakuumkammer (12) auf die gesamte Ausdehnung in x-Richtung erweiternde dritte Vakuumkammer (13) angeordnet ist,
- die zweite Vakuumkammer (12) eine Struktur aus einer Vielzahl paralleler und in x-Richtung verlaufender zeilenbildender Nuten (15) aufweist, die über einen ersten Verbindungskanal (22) in y-Richtung miteinander verbunden und mittels einer Zeilenschalteinrichtung (2) zur ersten Vakuumkammer (11) seriell freigeb- oder verschließbar sind,
- die dritte Vakuumkammer (13) eine Struktur aus einer Vielzahl paralleler und in y-Richtung verlaufender spaltenbildender Nuten (16) aufweist, die über einen zweiten Verbindungskanal (42) in x-Richtung miteinander verbunden und mittels einer Spaltenschalteinrichtung (4) zur ersten Vakuumkammer (11) seriell freigeb- oder verschließbar sind, wobei die Spaltenschalteinrichtung (4) ein Drehschieber (40) ist, der mittels eines Rotationsantriebs (45) positionierbar im Verteilergehäuse (3) gelagert ist, und
- die dritte Vakuumkammer (13) mittels der Zeilenschalteinrichtung (2) gleichzeitig abschnittsweise und entsprechend der Anzahl und den Positionen der zeilenbildenden Nuten (15) in Übereinstimmung zur zweiten Vakuumkammer (12) seriell in y-Richtung freigeb- oder verschließbar ist, um eine spalten- und zeilenweise Größenanpassung der wirksamen Fläche (W) des Tischs (1) in x- und / oder y-Richtung zu erreichen.

2. Vorrichtung nach Anspruch 1, **dadurch gekennzeichnet, dass** im Verteilergehäuse (3) die Spaltenschalteinrichtung (4) und der die spaltenbildenden Nuten (16) verbindende zweite Verbindungskanal (42) der dritten Vakuumkammer (13) angeordnet sind.

3. Vorrichtung nach Anspruch 1, **dadurch gekennzeichnet, dass** die erste Vakuumkammer (11) und die dritte Vakuumkammer (13) Zugangsbohrungen (18) für eine Verbindung zum Verteilergehäuse (3) aufweisen.

4. Vorrichtung nach Anspruch 1, **dadurch gekennzeichnet, dass** der zweite Verbindungskanal (42) radial zu einer Drehachse (41) des Drehschiebers (40) angeordnete Zugänge (44) aufweist.

5. Vorrichtung nach Anspruch 1, **dadurch gekennzeichnet, dass** der erste Verbindungskanal (22) der zweiten Vakuumkammer (12) parallel zu der zur dritten Vakuumkammer (13) weisenden Seite der zweiten Vakuumkammer (12) angeordnet ist.

6. Vorrichtung zum Fixieren von Objekten mittels Vakuum, umfassend einen in x- und y-Richtung ausgedehnten Tisch (1) mit mehreren Vakuumkammern, die zum flächigen Verteilen eines an den Tisch (1) angeschlossenen Vakuums in z-Richtung in den Tisch (1) eingebracht sind, und mit einer Tischplatte (10), die den Tisch (1) und die Vakuumkammern abdeckend angeordnet ist und rasterartig eine Vielzahl von Perforationslöchern (14) aufweist, wobei unmittelbar unter der Tischplatte (10) eine erste Vakuumkammer (11), ein Mindestformat (M) einer wirksamen Fläche (W) des Tischs (1) in x- und y-Richtung festlegend, anliegend an zwei benachbarten Seitenflächen des Tischs (1) angeordnet und permanent an eine mit dem Tisch (1) verbundene Vakuumabsaugung (5) angeschlossen ist und weitere Vakuumkammern, eine Erweiterung der wirksamen Fläche (W) über das Mindestformat (M) hinaus ermöglichend, anliegend an mindestens einer Seite der ersten Vakuumkammer (11) und / oder an mindestens einer der Seiten der weiteren Vakuumkammern angeordnet sind und alle weiteren Vakuumkammern eine schaltbare Verbindung zur Vakuumabsaugung (5) aufweisen, **dadurch gekennzeichnet, dass**
- auf dem Tisch (1) neben der ersten Vakuumkammer (11) eine die erste Vakuumkammer (11) auf die gesamte Ausdehnung in y-Richtung erweiternde zweite Vakuumkammer (12) und eine die erste Vakuumkammer (11) und die zweite Vakuumkammer (12) auf die gesamte Ausdehnung in x-Richtung erweiternde dritte Vakuumkammer (13) angeordnet ist,
- die zweite Vakuumkammer (12) eine Struktur aus einer Vielzahl paralleler und in x-Richtung verlaufender zeilenbildender Nuten (15) aufweist, die über einen ersten Verbindungskanal (22) in y-Richtung miteinander verbunden und mittels einer Zeilenschalteinrichtung (2) zur ersten Vakuumkammer (11) seriell freigeb- oder verschließbar sind, wobei die Zeilenschalteinrichtung (2) eine Anzahl von parallelen und in x-Richtung verlaufenden Blendenschiebern (20) aufweist, wobei die Anzahl der Blendenschieber (20) der Anzahl der zeilenbildenden Nuten (15) entspricht und die Blendenschieber (20) im Bereich der zweiten Vakuumkammer (12) durch den ersten Verbindungskanal (22) der zweiten Vakuumkammer (12) und durch die dritte Vakuumkammer (13) hindurchführend angeordnet sind,
- die dritte Vakuumkammer (13) eine Struktur aus einer Vielzahl paralleler und in y-Richtung verlaufender spaltenbildender Nuten (16) aufweist, die über einen zweiten Verbindungskanal (42) in x-Richtung miteinander verbunden und mittels einer Spaltenschalteinrichtung (4) zur ersten Vakuumkammer (11) seriell freigeb- oder verschließbar sind, und
- die dritte Vakuumkammer (13) mittels der Zeilenschalteinrichtung (2) gleichzeitig abschnittsweise und entsprechend der Anzahl und den Positionen der zeilenbildenden Nuten (15) in Übereinstimmung zur zweiten Vakuumkammer (12) seriell in y-Richtung freigeb- oder verschließbar ist, um eine spalten- und zeilenweise Größenanpassung der wirksamen Fläche (W) des Tischs (1) in x- und / oder y-Richtung zu erreichen.

7. Vorrichtung nach Anspruch 6, **dadurch gekennzeichnet, dass** die Blendenschieber (20) Durchbrüche (21) aufweisen, die entsprechend der Anzahl und den Positionen der spaltenbildenden Nuten (16) der dritten Vakuumkammer (13) und der Position des ersten Verbindungskanals (22) im Blendenschieber (20) angeordnet sind.

8. Vorrichtung nach Anspruch 7, **dadurch gekennzeichnet, dass** die Blendenschieber (20) mittels eines seriell wirksamen Linearantriebs (23) jeweils einzeln und nacheinander beweglich im Tisch (1) gelagert sind, sodass die Durchbrüche (21) zwischen einem freigebenden oder verschließenden Zustand hin und her bewegbar sind.

9. Vorrichtung nach einem der vorhergehenden Ansprüche, **dadurch gekennzeichnet, dass** die Erweiterung der wirksamen Fläche (W) zu beiden Seiten der ersten Vakuumkammer (11) in x- und / oder y-Richtung durch eine an der ersten Vakuumkammer (11) um die x-Achse gespiegelte Anordnung der zweiten Vakuumkammer (12) und der Zeilenschalteinrichtung (2) und / oder eine um die y-Achse gespiegelte Anordnung der dritten Vakuumkammer (13) und der Spaltenschalteinrichtung (4) erreichbar ist.

## Claims

1. A device for fixing objects by means of a vacuum, said device comprising a table (1) extending in the directions of x and y and comprising a plurality of vacuum chambers which are formed in the table (1) in the direction of z in order to evenly distribute a vacuum connected to the table (1), and comprising a tabletop (10) which is arranged to cover the table (1) and the vacuum chambers and has a plurality of perforation holes (14) arranged in a grid-like manner, wherein a first vacuum chamber (11) is arranged directly below the tabletop (10), said first vacuum chamber (11) defining a minimum format (M) of an effective surface area (W) of the table (1) in the directions of x and y and contacting two adjacent lateral surfaces of the table (1) as well as being permanently connected to a vacuum extraction means (5) which is connected to the table (1), and wherein further vacuum chambers, enabling an extension of the effective surface area (W) beyond the minimum format (M), are arranged in contact with at least one side of the first vacuum chamber (11) and/or at least one of the sides of the further vacuum chambers, and all further vacuum chambers have a switchable connection to the vacuum extraction means (5), **characterised in that**
- a distributor housing (3) is arranged at the table (1) by means of which distributor housing (3) the vacuum extraction means (5) is connected to the table (1),
- there are arranged on the table (1), in addition to the first vacuum chamber (11), a second vacuum chamber (12) extending the first vacuum chamber (11) to the entire extension in the direction of y, and a third vacuum chamber (13) extending the first vacuum chamber (11) and the second vacuum chamber (12) to the entire extension in the direction of x,
- the second vacuum chamber (12) comprises a structure consisting of a plurality of parallel, line-forming grooves (15) extending in the direction of x, which are connected to each other by a first connection channel (22) in the direction of y and can be opened or closed serially with respect to the first vacuum chamber (11) by means of a line-switching device (2),
- the third vacuum chamber (13) comprises a structure consisting of a plurality of parallel, column-forming grooves (16) extending in the direction of y, which are connected to each other via a second connection channel (42) in the direction of x and can be opened or closed serially with respect to the first vacuum chamber (11) by means of a column-switching device (4), wherein the column-switching device (4) is a rotary vane (40) which is supported in the distributor housing (3) so as to be positionable by means of a rotational drive (45), and
- the third vacuum chamber (13) can be opened or closed serially in the direction of y by means of the line-switching device (2), in a simultaneous, segmented manner and according to the number and positions of the line-forming grooves (15) in correspondence with the second vacuum chamber (12), so as to achieve a column- and line-wise size adjustment of the effective surface area (W) of the table (1) in the direction of x and/or y.

2. The device according to claim 1, **characterised in that** the distributor housing (3) has arranged therein the column-switching device (4) and the second connection channel (42) of the third vacuum chamber (13), said channel (42) connecting the column-forming grooves (16) with each other.

3. The device according to claim 1, **characterised in that** the first vacuum chamber (11) and the third vacuum chamber (13) comprise entrance bores (18) for connection to the distributor housing (3).

4. The device according to claim 1, **characterised in that** the second connection channel (42) comprises entrances (44) which are arranged radially with respect to an axis of rotation (41) of the rotary vane (40).

5. The device according to claim 1, **characterised in that** the first connection channel (22) of the second vacuum chamber (12) is arranged parallel to the side of the second vacuum chamber (12) facing the third vacuum chamber (13).

6. A device for fixing objects by means of a vacuum, said device comprising a table (1) extending in the directions of x and y and comprising a plurality of vacuum chambers which are formed in the table (1) in the direction of z in order to evenly distribute a vacuum connected to the table (1), and comprising a tabletop (10) which is arranged to cover the table (1) and the vacuum chambers and has a plurality of perforation holes (14) arranged in a grid-like manner, wherein a first vacuum chamber (11) is arranged directly below the tabletop (10), said first vacuum chamber (11) defining a minimum format (M) of an effective surface area (W) of the table (1) in the directions of x and y and contacting two adjacent lateral surfaces of the table (1) as well as being permanently connected to a vacuum extraction means (5) which is connected to the table (1), and wherein further vacuum chambers, enabling an extension of the effective surface area (W) beyond the minimum format (M), are arranged in contact with at least one side of the first vacuum chamber (11) and/or at least one of the sides of the further vacuum chambers, and all further vacuum chambers have a switchable connection to the vacuum extraction means (5), **characterised in that**
- there are arranged on the table (1), in addition to the first vacuum chamber (11), a second vacuum chamber (12) extending the first vacuum chamber (11) to the entire extension in the direction of y, and a third vacuum chamber (13) extending the first vacuum chamber (11) and the second vacuum chamber (12) to the entire extension in the direction of x,
- the second vacuum chamber (12) comprises a structure consisting of a plurality of parallel, line-forming grooves (15) extending in the direction of x, which are connected to each other by a first connection channel (22) in the direction of y and can be opened or closed serially with respect to the first vacuum chamber (11) by means of a line-switching device (2), wherein the line-switching device (2) comprises a number of parallel shutters (20) extending in the direction of x, wherein the number of shutters (20) corresponds to the number of line-forming grooves (15) and the shutters (20) are arranged in the area of the second vacuum chamber (12) so as to pass through the first connection channel (22) of the second vacuum chamber (12) and through the third vacuum chamber (13),
- the third vacuum chamber (13) comprises a structure consisting of a plurality of parallel, column-forming grooves (16) extending in the direction of y, which are connected to each other via a second connection channel (42) in the direction of x and can be opened or closed serially with respect to the first vacuum chamber (11) by means of a column-switching device (4), and
- the third vacuum chamber (13) can be opened or closed serially in the direction of y by means of the line-switching device (2), in a simultaneous, segmented manner and according to the number and positions of the line-forming grooves (15) in correspondence with the second vacuum chamber (12), so as to achieve a column- and line-wise size adjustment of the effective surface area (W) of the table (1) in the direction of x and/or y.

7. The device according to claim 6, **characterised in that** the shutters (20) comprise breakthroughs (21) which are arranged in the shutters (20) so as to correspond to the number and positions of the column-forming grooves (16) of the third vacuum chamber (13) and to the position of the first connection channel (22).

8. The device according to claim 7, **characterised in that** the shutters (20) are each supported so as to be individually and sequentially movable in the table (1) by means of a serially acting linear drive (23), so that the breakthroughs (21) can be moved back and forth between an opening or closing state.

9. The device according to any one of the preceding claims, **characterised in that** the extension of the effective surface area (W) on both sides of the first vacuum chamber (11) in the directions of x and/or y can be achieved by an arrangement of the second vacuum chamber (12) and the line-switching device (2) mirrored in the x-axis with respect to the first vacuum chamber (11) and/or by an arrangement of the third vacuum chamber (13) and the column-switching device (4) mirrored in the y-axis.

## Revendications

1. Dispositif pour la fixation d'objets au moyen d'un vide, ledit dispositif comprenant une table (1) s'étendant dans les directions x et y et présentant plusieurs chambres à vide introduites dans la table (1) dans la direction z pour la distribution étendue d'un vide relié à la table (1), et comprenant un plateau de table (10) qui est disposé de manière à recouvrir la table (1) et les chambres à vide et présente une pluralité de trous de perforation (14) à la manière d'une grille, une première chambre à vide (11) étant disposée directement sous le plateau de table (10), définissant un format minimal (M) d'une surface effective (W) de la table (1) dans les directions x et y, est appliquée contre deux surfaces latérales adjacentes de la table (1) et est reliée de façon permanente à une aspiration à vide (5) reliée à la table (1), et d'autres chambres à vide, permettant une agrandissement de la surface active (W) au-delà du format minimal (M), sont appliquées contreau moins un côté de la première chambre à vide (11) et/ou contre au moins un des côtés des autres chambres à vide, et toutes les autres chambres à vide présentent une liaison commutable avec l'aspiration à vide (5), **caractérisé en ce**
- **qu'**un boîtier de distribution (3) est disposé sur la table (1), au moyen duquel l'aspiration à vide (5) est reliée à la table (1),
- **qu'**une deuxième chambre à vide (12) agrandissant la première chambre à vide (11) sur toute son étendue dans la direction y et une troisième chambre à vide (13) agrandissant la première chambre à vide (11) et la deuxième chambre à vide (12) sur toute son étendue dans la direction x sont disposées sur la table (1) en plus de la première chambre à vide (11),
- **que** la deuxième chambre à vide (12) présente une structure constituée de plusieurs rainures (15) parallèles formant des rangées, qui s'étendent dans la direction x, sont reliées entre elles dans la direction y par un premier canal de liaison (22) et peuvent être ouvertes ou fermées en série par rapport à la première chambre à vide (11) au moyen d'un dispositif de commutation de rangées (2),
- **que** la troisième chambre à vide (13) présente une structure constituée de plusieurs rainures (16) parallèles formant des colonnes, qui s'étendent dans la direction y, sont reliées entre elles dans la direction x par un deuxième canal de liaison (42) et peuvent être ouvertes ou fermées en série par rapport à la première chambre à vide (11) au moyen d'un dispositif de commutation de colonnes (4), le dispositif de commutation de colonnes (4) étant une vanne rotative (40), qui est montée dans le boîtier de distribution (3) de manière à pouvoir être positionné au moyen d'un entraînement rotatif (45), et
- **que** la troisième chambre à vide (13) peut être ouverte ou fermée simultanément par sections et en fonction du nombre et des positions des rainures (15) formant des rangées en correspondance avec la deuxième chambre à vide (12) en série dans la direction y au moyen du dispositif de commutation de rangées (2), afin d'obtenir une adaptation de taille par colonnes et par rangées de la surface effective (W) de la table (1) dans la direction x et/ou dans la direction y.

2. Dispositif selon la revendication 1, **caractérisé en ce que** le dispositif de commutation de colonnes (4) et le deuxième canal de liaison (42) de la troisième chambre à vide (13) reliant les rainures (16) formant des colonnes sont disposés dans le boîtier de distribution (3).

3. Dispositif selon la revendication 1, **caractérisé en ce que** ladite première chambre à vide (11) et ladite troisième chambre à vide (13) comprennent des trous d'accès (18) pour la connexion audit boîtier de distribution (3).

4. Dispositif selon la revendication 1, **caractérisé en ce que** le deuxième canal de liaison (42) comprend des accès (44) disposés radialement par rapport à un axe de rotation (41) de la vanne rotative (40).

5. Dispositif selon la revendication 1, **caractérisé en ce que** le premier canal de liaison (22) de la deuxième chambre à vide (12) est disposé parallèlement au côté de la deuxième chambre à vide (12) tourné vers la troisième chambre à vide (13).

6. Dispositif pour la fixation d'objets au moyen d'un vide, ledit dispositif comprenant une table (1) s'étendant dans les directions x et y et présentant plusieurs chambres à vide introduites dans la table (1) dans la direction z pour la répartition bidimensionnelle d'un vide relié à la table (1), et comprenant un plateau de table (10) qui est disposée de manière à recouvrir la table (1) et les chambres à vide et présente une pluralité de trous de perforation (14) à la manière d'une grille, une première chambre à vide (11) étant disposée directement sous le plateau de table (10), définissant un format minimal (M) d'une surface effective (W) de la table (1) dans les directions x et y, est appliquée contre deux surfaces latérales adjacentes de la table (1) et est reliée de façon permanente à une aspiration à vide (5) reliée à la table (1), et d'autres chambres à vide, permettant une agrandissement de la surface active (W) au-delà du format minimal (M), sont appliquées contreau moins un côté de la première chambre à vide (11) et/ou contre au moins un des côtés des autres chambres à vide, et toutes les autres chambres à vide présentent une liaison commutable avec l'aspiration à vide (5), **caractérisé en ce**
- **qu'**une deuxième chambre à vide (12) agrandissant la première chambre à vide (11) sur toute son étendue dans la direction y et une troisième chambre à vide (13) agrandissant la première chambre à vide (11) et la deuxième chambre à vide (12) sur toute son étendue dans la direction x sont disposées sur la table (1) en plus de la première chambre à vide (11),
- **que** la deuxième chambre à vide (12) présente une structure constituée de plusieurs rainures (15) parallèles formant des rangées, qui s'étendent dans la direction x, sont reliées entre elles dans la direction y par un premier canal de liaison (22) et peuvent être ouvertes ou fermées en série par rapport à la première chambre à vide (11) au moyen d'un dispositif de commutation de rangées (2), le dispositif de commutation de rangées (2) présentant un nombre de vannes à guillotine (20) parallèles s'étendant dans la direction x, le nombre de vannes à guillotine (20) correspondant au nombre de rainures (15) formant des rangées, et les vannes à guillotine (20) étant disposées dans la région de la deuxième chambre à vide (12) de manière à passer par le premier canal de liaison (22) de la deuxième chambre à vide (12) et par la troisième chambre à vide (13),
- **que** la troisième chambre à vide (13) présente une structure constituée d'une pluralité de rainures (16) parallèles formant des colonnes qui s'étendent dans la direction y, sont reliées entre elles dans la direction x par un deuxième canal de liaison (42) et peuvent être ouvertes ou fermées en série par rapport à la première chambre à vide (11) au moyen d'un dispositif de commutation de colonnes (4), et
- **que** la troisième chambre à vide (13) peut être ouverte ou fermée simultanément par sections et en fonction du nombre et des positions des rainures (15) formant des rangées en correspondance avec la deuxième chambre à vide (12) en série dans la direction y au moyen du dispositif de commutation de rangées (2), afin d'obtenir une adaptation de taille par colonnes et par rangées de la surface effective (W) de la table (1) dans la direction x et/ou dans la direction y.

7. Dispositif selon la revendication 6, **caractérisé en ce que** les vannes à guillotine (20) comprennent des ouvertures (21) disposées en fonction du nombre et des positions des rainures (16) formant des colonnes de la troisième chambre à vide (13) et de la position du premier canal de liaison (22) dans la vanne à guillotine (20).

8. Dispositif selon la revendication 7, **caractérisé en ce que** les vannes à guillotine (20) sont montées dans la table (1) de manière à être mobile chacune individuellement et successivement au moyen d'un entraînement linéaire (23) agissant en série, de sorte que les ouvertures (21) peuvent être déplacées en va-et-vient entre un état d'ouverture ou de fermeture.

9. Dispositif selon l'une quelconque des revendications précédentes, **caractérisé en ce que** l'agrandissement de la surface effective (W) des deux côtés de la première chambre à vide (11) dans la direction x et/ou y peut être obtenue par disposition de la deuxième chambre à vide (12) et du dispositif de commutation de rangées (2) en miroir sur la première chambre à vide (11) autour de l'axe x et/ou par disposition de la troisième chambre à vide (13) et du dispositif de commutation de colonnes (4) en miroir autour de l'axe y.
